Europäisches Patentamt

European Patent Office

Office européen des brevets

(19)

(11) EP 1 596 638 A1

(12) **EUROPEAN PATENT APPLICATION**

(43) Date of publication:
**16.11.2005 Bulletin 2005/46**

(51) Int Cl.7: **H05B 33/14**, H05B 33/12, H01J 1/62

(21) Application number: **05010349.8**

(22) Date of filing: **12.05.2005**

(84) Designated Contracting States:
**AT BE BG CH CY CZ DE DK EE ES FI FR GB GR HU IE IS IT LI LT LU MC NL PL PT RO SE SI SK TR**
Designated Extension States:
**AL BA HR LV MK YU**

(30) Priority: **14.05.2004 JP 2004145545
21.07.2004 JP 2004213484**

(71) Applicant: **KABUSHIKI KAISHA TOYOTA JIDOSHOKKI
Kariya-shi, Aichi-ken (JP)**

(72) Inventors:
 • **Besshi, Noriyuki
  Kariya-shi Aichi-ken (JP)**

 • **Ishikawa, Haruyuki
  Kariya-shi Aichi-ken (JP)**
 • **Takeuchi, Norihito
  Kariya-shi Aichi-ken (JP)**
 • **Toeda, Minoru
  Kariya-shi Aichi-ken (JP)**
 • **Yoshida, Mikio
  Kariya-shi Aichi-ken (JP)**
 • **Koike, Shuji
  Kariya-shi Aichi-ken (JP)**

(74) Representative: **TBK-Patent
Bavariaring 4-6
80336 München (DE)**

(54) **Lighting apparatus**

(57)     A luminescent panel has a light emitting portion for emitting isotropic light and a non-light emitting portion. A brightness compensating member has an incident portion and a light exit portion. The incident portion includes at least one inclined surface that is inclined relative to the light exit portion. The inclined surface is arranged to correspond to the non-light emitting portion.

The inclined surface is configured so that the brightness of a section of the brightness compensating member that corresponds to the light emitting portion is substantially equal to the brightness of a section of the brightness compensating member that corresponds to the non-light emitting portion. Therefore, a substantially uniform brightness is obtained from the light exit portion.

Fig.1 (a)

EP 1 596 638 A1

**Fig.1 (b)**

**Description**

BACKGROUND OF THE INVENTION

The present invention relates to a lighting apparatus. Specifically, the present invention relates to a lighting apparatus having a plurality of luminescent panels, in which each panel includes a light emitting portion for emitting isotropic light such as an electroluminescent element (EL element), and a non-light emitting portion provided around the light emitting portion (EL element), and the panels are arranged so that the non-light emitting portions are adjacent to each other.

The present invention also relates to a lighting apparatus having a luminescent panel that includes a light emitting portion for emitting isotropic light such as an EL element, and a non-light emitting portion.

Conventionally, lighting apparatuses having EL elements arranged on a transparent substrate have been proposed. There has also been proposed a technique for using such lighting apparatus as a backlight for a liquid crystal display. There is a demand for large-area EL elements. However, EL elements are extremely thin, having an EL layer of thickness of several tens to several hundreds nanometers. It is thus difficult to uniformly form an EL layer in a large area. Such attempt would result in a reduced yield.

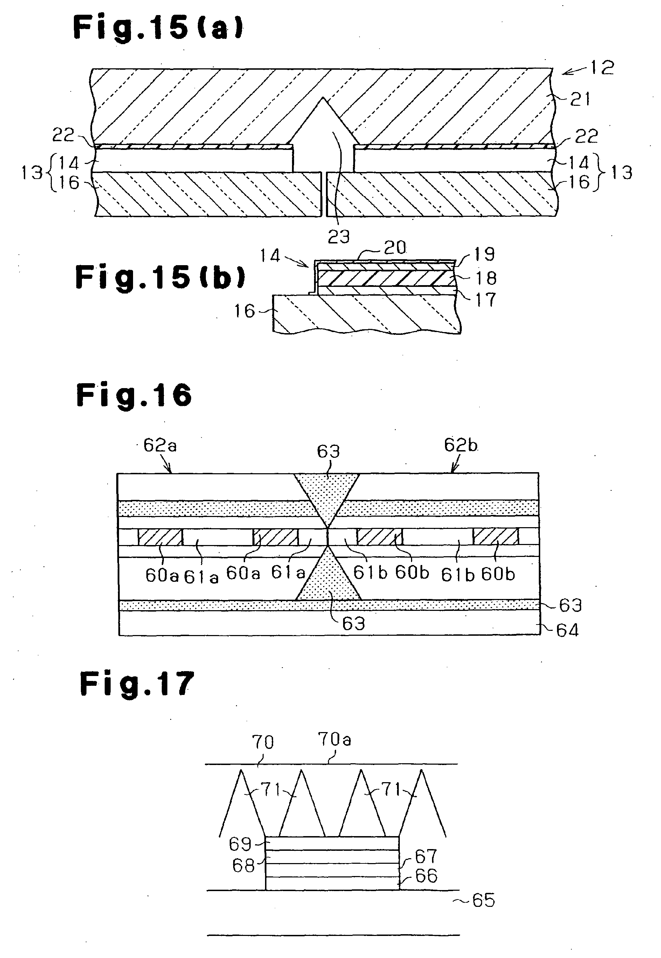

Also, there is proposed an EL display that is formed by joining display panels. This EL display does not degrade a light emitting portion and makes junctions of the display panels inconspicuous (for example, refer to Japanese Laid-Open Patent Publication No. 2002-297065). In this EL display, light emitting layers 60a, 60b are separated by protective layers 61a, 61b as shown in Fig. 16. Edges of compact panels 62a, 62b are beveled at the upper and lower surfaces. Adhesive 63 fills a narrow space between facing pair of the protective layers 61a, 61b of compact panels 62a, 62b. The adhesive 63 also fills upper and lower spaces located above and below the narrow space. Accordingly, the compact panels 62a, 62b are joined to each other. Specifically, the compact panels 62a, 62b are joined to each other so that the pixel pitch at the junction between the compact panels 62a, 62b (the distance between an adjacent pair of the light emitting layers 60a, 60b) is equal to the pixel pitch in each of the compact panels 62a, 62b (the distance between each adjacent pair of the light emitting layers 60a and the distance between each adjacent pair of the light emitting layers 60b). The compact panels 62a, 62b are attached to a protective substrate 64 with the adhesive 63. To reduce optical imperfections, an adhesive having optical properties that is close to the refractive index of glass in the visible wavelength range is used as the adhesive 63. For example, an ultraviolet curing adhesive or a polymeric adhesive is used as the adhesive 63.

In a typical organic EL element, some of light emitted from fluophor in a light emitting layer is totally reflected at an interface between air and a transparent substrate at a light extracting side. The totally reflected light cannot be effectively used. There have been proposed a number of organic EL elements that are designed to reduce such a disadvantage (for example, refer to Japanese Laid-Open Patent Publication No. 2003-397052). In the organic EL element of the publication, an anode 66, a hole transport layer 67, a light emitting layer 68, and a transparent cathode 69 are laminated on a substrate 65 as shown in Fig. 17. An unillustrated protective film is formed on the cathode 69. A light angle changing panel 70 is attached to the protective film with an optical adhesive. V-shaped grooves 71 are formed on a surface of the angle changing panel 70 that faces the substrate 65. Without the V-shaped grooves 71, some of light emitted by the light emitting layer 68 is totally reflected on a light emitting surface (light exit surface) 70a and is trapped in the EL element. However, since the EL element of Fig. 17 has the V-shaped grooves 71, light that is inclined with respect to the light emitting surface (light exit surface) 70a is totally reflected at interface between each V-shaped groove 71 and air so that the angle of the light is changed. The light then exits to the air. This improves the light extraction efficiency.

Further, there have been proposed organic EL panels that improve the utilization of light to obtain a bright image (for example, refer to Japanese Laid-Open Patent Publication No. 2003-282255). The organic EL panel of the publication has organic EL elements, which function as pixels. The organic EL elements are formed in a matrix and as a film on a first transparent substrate. A second transparent substrate is located on the organic EL film. The second transparent substrate is fixed to the organic EL film with an adhesive layer. On a surface of the second transparent substrate that faces the first transparent substrate, V-shaped grooves of a grid pattern are formed except for sections corresponding to the pixels. A reflection film is formed on each inclined surface of the V-shaped grooves. Light that is incident from each organic EL element and on the second transparent substrate, and advances toward a side of the second transparent substrate is reflected by one of the reflection films and exits the second transparent substrate.

The EL display disclosed in Japanese Laid-Open Patent Publication No. 2002-297065 has no pixels at the junction between the compact panels 62a, 62b. The junctions are therefore non-light emitting portions. Therefore, it is not necessary that light having a brightness equal to the brightness of sections corresponding to the light emitting layers 60a, 60b be emitted from sections corresponding to the adhesive 63. Therefore, the art of this publication has no optical problems as a method for joining the compact panels 62a, 62b to each other. However, when applied to a panel in a lighting apparatus used as a backlight for a liquid crystal display, the method has the following drawbacks.

For example, light emitted from the light emitting layers 60a, 60b toward the edges of the compact panels 62a, 62b is reflected, absorbed, or dispersed at interfaces between the adhesive 63 and the beveled edges of the compact panels 62a, 62b. Also, light that passes through the adhesive 63 is absorbed or dispersed by the adhesive 63. As a result, the brightness of the section of the adhesive 63 is less than the brightness of other sections. As a result, the boundary between the compact panels 62a, 62b becomes dim. Also, if cracks are caused while beveling the edges of the compact panels 62a, 62b, the cracks would affects the apparatus, and the compact panels 62a, 62b with cracks therefore cannot be used. This reduces yields.

Japanese Laid-Open Patent Publications No. 2003-347052 and No. 2003-282255 do not disclose or suggest any technique for enlarging the size of screens of organic EL elements. The objectives of the publications are to extract light that is emitted by light emitting layers but conventionally cannot be extracted due to total reflection, for example, at light exit surfaces. However, the publications do not disclose or suggest any technique for obtaining a lighting apparatus with a large light emitting area by causing the same brightness of light to be emitted from sections corresponding to non-light emitting portions of organic EL elements as the brightness of light emitting sections of the EL elements.

## SUMMARY OF THE INVENTION

Accordingly, it is an objective of the present invention to provide a lighting apparatus having a plurality of luminescent panels emitting isotropic light, which apparatus eliminates necessity for cutting the luminescent panels and effectively uses light from light emitting portions, thereby preventing sections facing non-light emitting portions between luminescent panels from becoming dim.

Another objective of the present invention is to provide a lighting apparatus having a luminescent panel with a light emitting portion and a non-light emitting portion, the light emitting portion emitting isotropic light, which apparatus emits light from a light exit portion, the area of which is larger than that of the light emitting portion, and in which apparatus the brightness of a section of the light exit portion that corresponds to the light emitting portion is substantially equal to the brightness of a section of the light exit portion that corresponds to the non-light emitting portion.

To achieve the above-mentioned objective, the present invention provides a lighting apparatus. A luminescent panel has a light emitting portion for emitting isotropic light and a non-light emitting portion. A brightness compensating member has an incident portion, on which light is incident, and a light exit portion, through which light exits. The incident portion includes at least one inclined surface that is inclined relative to the light exit portion. The inclined surface is arranged to correspond to the non-light emitting portion. The inclined surface is configured so that the brightness of a section of the brightness compensating member that corresponds to the light emitting portion is substantially equal to the brightness of a section of the brightness compensating member that corresponds to the non-light emitting portion.

Further, the present invention provides a lighting apparatus including a plurality of luminescent panels. Each luminescent panel has a light emitting portion for emitting isotropic light and a non-light emitting portion provided around the light emitting portion. The luminescent panels are arranged so that the non-light emitting portions are adjacent to each other. A brightness compensating member is formed of a transparent plate and is arranged at a side of the luminescent panels through which light exits to correspond to the luminescent panels. A surface of the brightness compensating member that faces the luminescent panels has a V-shaped groove that extends along the non-light emitting portions. The V-shaped groove is formed so that the brightness of a section of the brightness compensating member that corresponds to the light emitting portion is substantially equal to the brightness of a section of the brightness compensating member that corresponds to the non-light emitting portions.

Further, the present invention provides a lighting apparatus including a plurality of adjoining luminescent panels each having a light emitting portion for emitting isotropic light and an auxiliary electrode. A section of each luminescent panel on which the auxiliary electrode is formed forms a non-light emitting portion. A brightness compensating member is formed of a transparent plate and is arranged at a side of the luminescent panels through which light exits to correspond to the luminescent panels. A surface of the brightness compensating member that faces the luminescent panels has a V-shaped groove that is arranged to correspond to the non-light emitting portions. The V-shaped groove is formed so that the brightness of a section of the brightness compensating member that corresponds to the light emitting portions is substantially equal to the brightness of a section of the brightness compensating member that corresponds to the non-light emitting portions.

Further, the present invention provides a lighting apparatus including a plurality of luminescent panels each having a light emitting portion for emitting isotropic light and a non-light emitting portion provided around the light emitting portion. The luminescent panels are arranged so that the non-light emitting portions are adjacent to each other. A brightness compensating member is formed of a transparent plate and is arranged at a side of the luminescent panels through which light exits to correspond to the luminescent panels. A surface of the brightness compensating member that faces the luminescent panels has a V-shaped groove that extends along the non-light emitting portions. The V-shaped groove is formed so that the brightness of a section of the brightness compensating member that corresponds to the non-light emitting portion is increased to approaches the brightness of a section of the brightness compensating member that corresponds to the light emitting portions.

Other aspects and advantages of the invention will become apparent from the following description, taken in conjunction with the accompanying drawings, illustrating by way of example the principles of the invention.

BRIEF DESCRIPTION OF THE DRAWINGS

The invention, together with objects and advantages thereof, may best be understood by reference to the following description of the presently preferred embodiments together with the accompanying drawings in which:

Fig. 1(a) is a partial cross-sectional view illustrating a liquid crystal display provided with a lighting apparatus according to a first embodiment of the present invention;

Fig. 1(b) is a partial cross-sectional view of the luminescent panel shown in Fig. 1(a);

Fig. 2 is a diagrammatic view showing an operation of the lighting apparatus shown in Fig. 1(a);

Fig. 3 is a partial plan view illustrating the lighting apparatus shown in Fig. 1(a);

Figs. 4(a) and 4(b) are diagrammatic views for obtaining relational equations between the viewing angle and the apex angle of a V-shaped groove in the lighting apparatus shown in Fig. 1(a);

Fig. 5 is a partial cross-sectional view illustrating a liquid crystal display provided with a lighting apparatus according to a second embodiment of the present invention;

Fig. 6 is a partial cross-sectional view illustrating a liquid crystal display provided with a lighting apparatus according to a third embodiment of the present invention;

Fig. 7 is a partial cross-sectional view illustrating a liquid crystal display provided with another lighting apparatus according to the third embodiment of the present invention;

Figs. 8(a), 8(b), and 8(c) are diagrammatic views showing the relationship of the viewing angle, the apex angle of a V-shaped groove, the apex angle of a second V-shaped groove, and the thickness of a brightness compensating member;

Fig. 9 is a plan view illustrating a lighting apparatus according to a fourth embodiment of the present invention;

Fig. 10 is a partial cross-sectional view illustrating the lighting apparatus shown in Fig. 9;

Fig. 11 is a diagrammatic view showing the relationship of the viewing angle, the inclined surface, and the thickness of the brightness compensating member of the lighting apparatus shown in Fig. 9;

Fig. 12 is a plan view illustrating a luminescent panel according to a fifth embodiment of the present invention;

Fig. 13 is a partial cross-sectional view illustrating the lighting apparatus shown in Fig. 12;

Fig. 14 is a partial cross-sectional view illustrating a lighting apparatus according to another embodiment of the present invention;

Fig. 15(a) is a partial cross-sectional view illustrating a lighting apparatus according to a further embodiment of the present invention;

Fig. 15(b) is a partial cross-sectional view of the luminescent panel shown in Fig. 15(a);

Fig. 16 is a partial cross-sectional view illustrating a prior art EL display; and

Fig. 17 is a partial cross-sectional view illustrating another prior art EL display.

DETAILED DESCRIPTION OF THE PREFERRED EMBODIMENTS

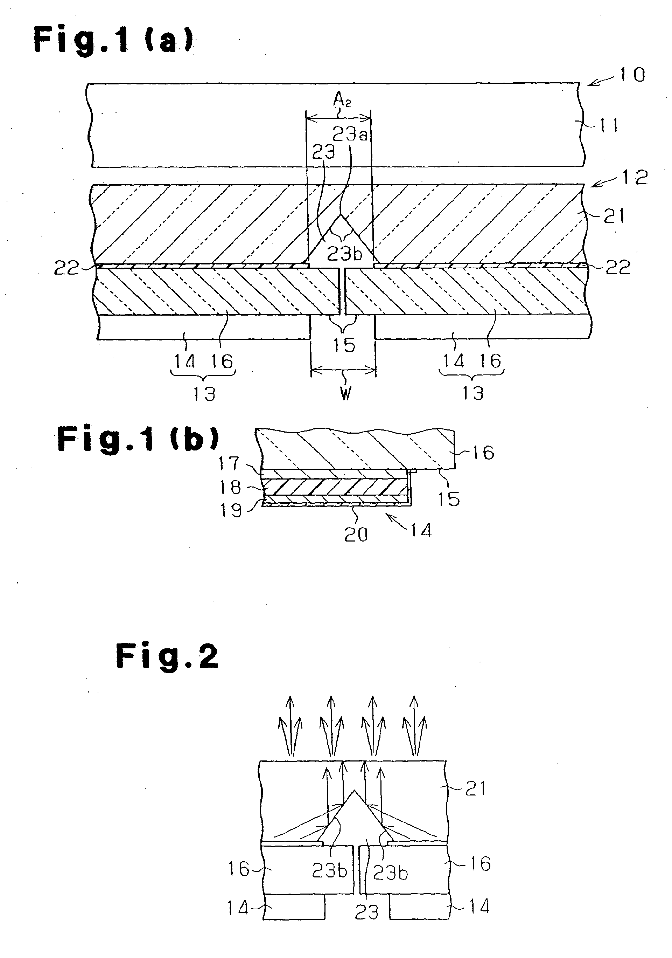

A lighting apparatus 12 according to a first embodiment of the present invention will now be described referring to Figs 1(a) to 4(b). The lighting apparatus 12 is used as a backlight of a liquid crystal display 10. In the cross-sectional views, part of hatching is omitted.

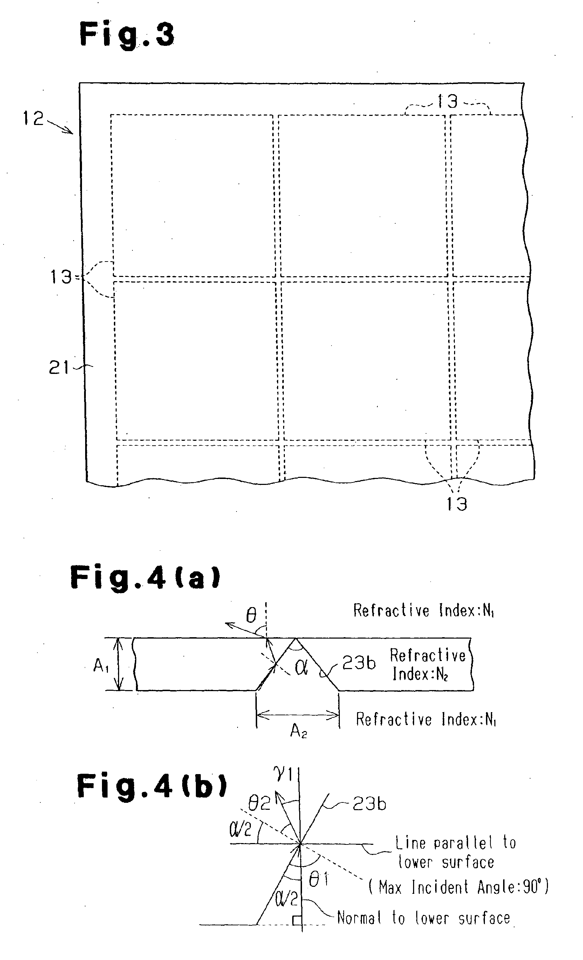

As shown in Fig. 1(a), the liquid crystal display 10 includes a transmissive liquid crystal panel 11 and the lighting apparatus 12 located on the back of the liquid crystal panel 11, or on a surface at a side opposite to a display surface. The lighting apparatus 12 has luminescent panels 13. Each luminescent panel 13 includes a light emitting portion 14, which emits isotropic light, and a non-light emitting portion 15 provided around the light emitting portion 14. The luminescent panels 13 are arranged so that the non-light emitting portions 15 are arranged adjacent to each other. The number of the luminescent panels 13 is determined according the size of each luminescent panel 13 and the size of the lighting apparatus 12. The luminescent panels 13 are aligned in one or more rows. In this embodiment, the luminescent panels 13 are aligned in a plurality of rows as shown in Fig. 3. In this specification, "to emit isotropic light" refers to a state where light emitted by each light emitting portion 14 is directed in every direction with an equal intensity.

As shown in Fig. 1(b), each luminescent panel 13 includes a transparent substrate 16 and an electroluminescent element (EL element), which functions as the light emitting portion 14, provided on the substrate 16. In this embodiment, glass substrates are used as the transparent substrates 16, and organic EL elements are used as the EL elements. Each organic EL element includes a first electrode 17, an organic EL layer 18, and a second electrode 19, which are laminated in this order on the transparent substrate 16. Each organic EL element is coated with a protective film 20, so that the organic EL layer 18 is not adversely affected by water (water vapor) and oxygen. In this embodiment, each first electrode 17 forms an anode, and each second electrode 19 forms a cathode. Each organic EL element is a "bottom emission type", in which light from the organic EL layer 18 is extracted through the transparent substrate 16. Therefore, the first electrodes 17 are of a light transmission type, and the second electrodes 19 are of a light reflection type. The first electrodes 17, the organic EL layers 18, the second electrodes 19, and the protective films 20 each have the materials and configurations used in known organic EL elements. The organic EL elements may be ones that have an emission spectrum only in part of the visible range may be used.

The EL element, or the light emitting portion 14, formed on each transparent substrate 16 needs to have terminal electrodes and connecting lines (neither is shown) for connecting the anode and cathode with, for example, an external drive circuit. The terminal electrodes and connecting lines are provided around the EL element on each transparent substrate 16, on which the EL element is formed. Since no light exits from this section even if the EL element emits light, the section is referred to as the non-light emitting portion 15.

As shown in Fig. 1(a), the transparent substrates 16 of the luminescent panels 13 are attached to a brightness compensating member 21, which is formed of a transparent plate, with an adhesive 22. That is, the brightness compensating member 21 is located at a side of the luminescent panels 13 through which light exits and at a position corresponding to the luminescent panels 13. "Transparent" refers to a property of having transparency to light of wavelength emitted by the light emitting portions 14, and generally, to a property of having a transmittance of 70% or more to visible light. The adhesive 22 is an ultraviolet curing adhesive or a polymeric adhesive having the same or similar refractive index as the brightness compensating member 21. To have a "similar refractive index" refers to a state where the difference in the refractive index between the adhesive 22 and the brightness compensating member 21 is no more than several percent.

The brightness compensating member 21 may be made of any material that is transparent and easy to machine. For example, an acrylic resin, glass, polyvinyl chloride, polyethylene, polystyrene, or polycarbonate may be used. In this embodiment, the brightness compensating member 21 is formed of the same glass as that of the transparent substrate 16.

The brightness compensating member 21 may be made by using a mold or by machining the surface of a plate-like substrate.

V-shaped grooves 23 are formed on a surface of the brightness compensating member 21 that faces the luminescent panels 13. Each V-shaped groove 23 is located in a position that corresponds to the non-light emitting portions 15 and a section between the non-light emitting portions 15 of an adjacent pair of the luminescent panels 13. The V-shaped grooves 23 are configured so that the brightness of sections of the brightness compensating member 21 that correspond to the light emitting portions 14 is substantially the equal to the brightness of sections of the brightness compensating member 21 that correspond to the non-light emitting portions 15. In other words, the V-shaped grooves 23 are configured so that the brightness of sections of the brightness compensating member 21 that correspond to the non-light emitting portions 15 is increased to approach the brightness of sections of the brightness compensating member 21 that correspond to the light emitting portions 15. A state where "the brightness of sections of the brightness compensating member 21 that correspond to the light emitting portions 14 is substantially equal to the brightness of sections of the brightness compensating member 21 that correspond to the non-light emitting portions 15" refers to a state where the ratio of the luminance of the sections of the brightness compensating member 21 that correspond to the light emitting portions 14 to the luminance of the sections of the brightness compensating member 21 that correspond to the non-light emitting portions 15 is no less than 0.8 in the present embodiment, in which the lighting apparatus 12 is used as the backlight of the liquid crystal display 10. In a case where the lighting apparatus 12 used as an ordinary lighting apparatus, the state of substantially equal brightness refers to a state where the luminance ratio is no less than 0.5.

Inclined surfaces 23b of each V-shaped groove 23 are either optically polished or mirror finished. The width $A_2$ of the open end of each V-shaped groove 23 is wider than the width W of the space between the light emitting portions 14 of the corresponding pair of the luminescent panels 13. That is, the luminescent panels 13 are adhered to the brightness compensating member 21 so that the end of each light emitting portion 14 is located in the corresponding V-shaped groove 23 when the brightness compensating member 21 is viewed from the side of the luminescent panels 13. The degree by which the width $A_2$ of the open end of each V-shaped groove 23 is wider than the width W between the light emitting portions 14 of the corresponding two luminescent panels 13 is set so that the width $A_2$ of the open end is not made narrower than the width W due to an error within tolerance when the brightness compensating member 21 is machined.

Each V-shaped groove 23 is formed so that the depth $A_1$ of the V-shaped groove 23, the width $A_2$ of the open end of the V-shaped groove 23, the apex angle $\alpha$ of the V-shaped groove 23, the refractive index $N_1$ of air, the refractive index $N_2$ of the brightness compensating member 21, and the viewing angle $\theta$ of the brightness compensating member 21 satisfy the following two equations.

$$A_1 = A_2/\{2\tan(\alpha/2)\} \tag{1}$$

$$e = \arcsin[(N_2/N_1)\sin\{90 - \alpha/2 - \arcsin(N_1/N_2)\}] \tag{2}$$

The "viewing angle" refers to an angle defined by the direction closest to the luminescent panels 13 among directions in which the non-light emitting portions 15 of each adjacent luminescent panel 13 are not visible when the lighting apparatus 12 is viewed from the side of the brightness compensating member 21, and the normal vector to a plane of the brightness compensating member 21 except for the V-shaped grooves 23, which normal vector is perpendicular to the luminescent panels 13. The width $A_2$ of the open end of each V-shaped groove 23 is determined in accordance with the width of each non-light emitting portion 15 of the luminescent panels 13. The refractive index $N_1$ of air cannot be changed. Also, the refractive index $N_2$ of the brightness compensating member 21 cannot be changed by a great degree. Thus, the apex angle $\alpha$ of the V-shaped grooves 23 and the depth $A_1$ of the V-shaped grooves 23 are determined appropriately depending on which of reduction of the thickness of the brightness compensating member 21 and increase of the viewing angle e is given a higher priority.

An operation of the lighting apparatus 12 configured as described above will hereafter be described.

When voltage is applied to the first electrodes 17 and the second electrodes 19 through a drive control apparatus (not shown), the light emitting portions 14 of each luminescent panel 13 emit light. Light emitted by the light emitting portions 14 is incident on the brightness compensating member 21 through the transparent substrates 16 and the adhesive 22. Due to the isotropic property of the light emitting portions 14, part of light emitted by each light emitting portion 14 advances in a slanting direction toward the edge of the corresponding luminescent panel 13 through the transparent substrate 16. Then, as shown in Fig. 2, part of light that is incident on the brightness compensating member 21 in a slanting direction is reflected at the inclined surfaces 23b of each V-shaped groove 23 and advances in a direction perpendicular to the light exit surface of the brightness compensating member 21.

Therefore, the same brightness is obtained from sections of the lighting apparatus 12 each of which corresponds to the non-light emitting portions 15 of an adjacent pair of the luminescent panels 13 as the brightness from sections of the lighting apparatus 12 that correspond to the light emitting portions 14. Therefore, sections of the lighting apparatus 12 corresponding to the non-light emitting portions 15 between the luminescent panels 13 are prevented from becoming dim. Light that exits through the light exit surface of the brightness compensating member 21 toward the liquid crystal panel 11 is effectively used as illuminating light of the lighting apparatus 12. A user of the liquid crystal display 10 can see the things displayed on the liquid crystal panel 11 with the illuminating light of the lighting apparatus 12.

Referring to Figs. 4(a) and 4(b), the procedure for obtaining the equations (1), (2), which define the relationship between the viewing angle $\theta$ and the apex angle $\alpha$ of the brightness compensating member 21, will now be explained. The viewing angle $\theta$ is defined by a straight line perpendicular to the light exit surface of the brightness compensating member 21 and the direction of light that exits the brightness compensating member 21 after reaching one of the inclined surface 23b of one of the V-shaped groove 23 at an incident angle of 90 degrees from the outside of the brightness compensating member 21. The following equation is satisfied when depth of each V-shaped groove 23 is expressed by $A_1$, the width of the open end of each V-shaped groove 23 is expressed by $A_2$, and the apex angle of each V-shaped groove 23 is expressed by $\alpha$ as shown in Fig. 4(a).

$$\tan(\alpha/2) - (A_2/2)/A_1 \tag{3}$$

As shown in Fig. 4(b), with respect to light that is incident on each inclined surface 23b of each V-shaped groove 23 from the outside at an incident angle of 90 degrees, the following equation is satisfied due to Snell's law if the incident angle $\theta1$ to the inclined surface 23b of the V-shaped groove 23 is 90 degrees, the refractive angle is expressed by $\theta2$, and the incident angle of the light exiting from the brightness compensating member 21 to an air layer is expressed by $\gamma1$.

$$N_1\sin\theta = N_2\sin(\gamma1) \tag{4}$$

$$N_2\sin(\theta2) = N_1\sin(\theta1) = N_1 \tag{5}$$

$$\theta2 + \gamma1 + \alpha/2 = 90 \tag{6}$$

Therefore, the equation (1) defining the depth $A_1$ of each V-shaped groove 23 is obtained based on the equation (3), and the equation (2) defining the viewing angle $\theta$ is obtained based on the equations (4) to (6).

$$A_1 = (A_2/2)/\{\tan(\alpha/2)\} = A_2/\{2\tan(\alpha/2)\} \tag{1}$$

$$\theta = \arcsin [(N_2/N_1) \sin\{ 90 - \alpha/2 - \arcsin (N_1/N2)\}] \tag{2}$$

For example, if the apex angle $\alpha$ is set to 12.5 degrees when the width $A_2$ of the open end of each V-shaped groove 23 is 2.2 mm, the viewing angle $\theta$ is approximately 82 degrees, and the depth $A_1$ of each V-shaped groove 23 is 10.0 mm. Further, if the apex angle $\alpha$ is set to 40 degrees when the width $A_2$ of the open end of each V-shaped groove 23 is 2.2 mm, the viewing angle $\theta$ is approximately 44 degrees, and the depth $A_1$ of each V-shaped groove 23 is 3.0 mm. Thus, by forming the brightness compensating member 21 so that the equations (1) and (2) are satisfied, the apex angle $\alpha$ of the V-shaped grooves 23 and the depth $A_1$ of the V-shaped grooves 23 are easily determined appropriately depending on which of reduction of the thickness of the brightness compensating member 21 and increase of the viewing angle $\theta$ is given a higher priority.

This embodiment provides the following advantages.

(1) The luminescent panels 13 are aligned and joined to each other. Thus, compared to a case where a single luminescent panel is used, a larger area can be illuminated.

(2) The lighting apparatus 12 includes the luminescent panels 13 each having the light emitting portion 14, which emits isotropic light, and the non-light emitting portion 15 provided around the light emitting portion 14. The luminescent panels 13 are arranged so that the non-light emitting portions 15 are adjacent to each other. The brightness compensating member 21 is located at a side of the luminescent panels 13 through which light exits and at a position corresponding to the luminescent panels 13. The V-shaped grooves 23 are formed on a surface of the brightness compensating member 21 that faces the luminescent panels 13. Each V-shaped groove 23 is located in a position that corresponds to the non-light emitting portions 15 and a section between the non-light emitting portions 15 of an adjacent pair of the luminescent panels 13. The V-shaped grooves 23 are configured so that the brightness of sections of the brightness compensating member 21 that correspond to the light emitting portions 14 is substantially equal to the brightness of sections of the brightness compensating member 21 that correspond to the non-light emitting portions 15. Therefore, the luminescent panels 13 do not need to be machined, and light from the light emitting portions 14 is effectively used, thereby preventing sections of the lighting apparatus 12 that correspond to the non-light emitting portions 15 between the luminescent panes 13 from becoming dim.

(3) The width $A_2$ of the open end of each V-shaped groove 23 is wider than the width W of the space between the light emitting portions 14 of the corresponding pair of the luminescent panels 13. Therefore, even if the width $A_2$ of the open end of each V-shaped groove 23 is not precisely equal to the width W of the space between the light emitting portions 14 of the corresponding luminescent panels 13, machining the V-shaped grooves 23 within a tolerable error prevents the non-light emitting portions 15 from being visible. In other words, linear dim sections do not appear on the lighting apparatus 12.

(4) The inclined surfaces 23b of each V-shaped groove 23 are either optically polished or mirror finished. Therefore compared to a case where the inclined surfaces 23b of each V-shaped groove 23 are not optically polished or mirror finished, attenuation of light due to scattering and absorption is reduced. Thus, the amount of light that is reflected by the V-shaped grooves 23 and exits through the light exit side of the brightness compensating member 21 is increased. That is, light emitted by the light emitting portions 14 is effectively used.

(5) Each V-shaped groove 23 is formed so that the depth $A_1$ of the V-shaped groove 23, the width $A_2$ of the open end of the V-shaped groove 23, the apex angle $\alpha$ of the V-shaped groove 23, the refractive index $N_1$ of air, the refractive index $N_2$ of the brightness compensating member 21, and the view angle $\theta$ satisfy the following two equations.

$$A_1 = A_2/\{2\tan(\alpha/2)\} \tag{1}$$

$$\theta = \arcsin[(N_2/N_1)\sin\{90 - \alpha/2 - \arcsin(N_1/N_2)\}] \tag{2}$$

Thus, the apex angle $\alpha$ of the V-shaped grooves 23 and the depth $A_1$ of the V-shaped grooves 23 are easily determined appropriately depending on which of reduction of the thickness of the brightness compensating member 21 and increase of the viewing angle $\theta$ is given a higher priority.

(6) The luminescent panels 13 are attached to the brightness compensating member 21 with the adhesive 22. Therefore, compared to a configuration in which liquid or gel, the refractive index of which is close to those of the transparent substrates 16 and the brightness compensating member 21, is located between the luminescent panels 13 and the brightness compensating member 21, the assembly of the luminescent panels 13 and the brightness compensating member 21 is facilitated.

(7) The light emitting portions 14 are formed of EL elements. Therefore, the light emitting portions 14, which emit isotropic light, are easily formed or easy to come by.

(8) The light emitting portions 14 are formed of organic EL elements. Thus, compared to a case where inorganic EL elements are used, the light emitting portions 14 are driven by a lower voltage.

(9) The lighting apparatus 12 is used as the backlight of the liquid crystal display 10. Brightness unevenness in the liquid crystal,display 10 of a large screen is thus reduced.

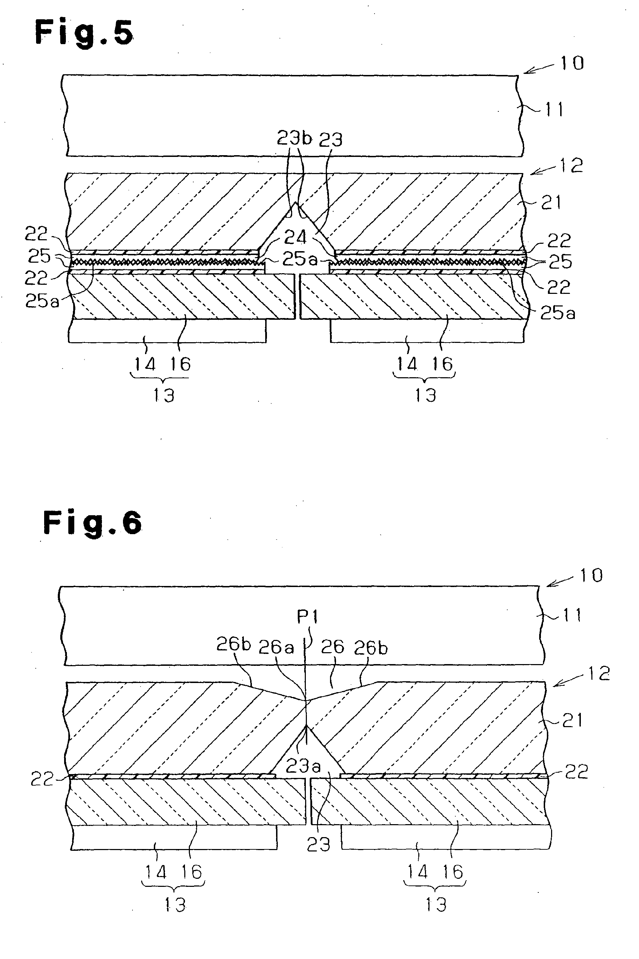

A second embodiment of the present invention will now be described with reference to Fig. 5. A lighting apparatus 12 of the present embodiment is different from the lighting apparatus 12 of the first embodiment in that the apparatus 12 of the present embodiment is suitable for use in a color liquid crystal display. Specifically, the lighting apparatus 12 of the second embodiment is different form the first embodiment in that light emitting portions 14 emit white light, and that light of the same color exits from the entire light exit surface of a brightness compensating member 21. Similar or the same reference numerals are given to those components that are similar or the same as the corresponding components of the first embodiment and detailed explanations are omitted. Fig. 5 is partial cross-sectional view illustrating a liquid crystal display 10.

Organic EL layers 18 (see Fig. 1(b)) of organic EL elements forming the light emitting portions 14 are configured to emit white light. As a configuration for emitting white light, one of conventional configurations may be used. Such configurations include: a configuration in which a single layer is two-dimensionally divided into minute sections each emitting red, green, or blue light, so that the layer emits white light as a whole; a configuration in which layers each emitting red, green or blue light are laminated so that the laminated layers emit white light as a whole; and a configuration in which pigments of red, green, and blue are dispersed among host molecules or polymer molecules.

On a surface of the brightness compensating member 21 that faces the luminescent panels 13, diffusion portions 24 are provided in sections except for the V-shaped grooves 23. On the surface of the brightness compensating member 21 where the V-shaped grooves 23 are formed, diffusion sheets 25 are optically integrated with the brightness compensating member 21 with adhesive 22. Each diffusion sheet 25 has a diffusion surface 25a that faces the corresponding luminescent panel 13. The diffusion sheets 25 form the diffusion portions 24. The state where each diffusion sheet 25 is optically integrated with the brightness compensating member 21 refers to a state where the least amount of air exists between the diffusion sheet 25 and the brightness compensating member 21, or a state where the refractive index of a material used in the adhesive 22 or a tacky agent is equal to or within a several percent difference from the refractive index of the brightness compensating member 21. The brightness compensating member 21 is arranged so that a space exists between each diffusion portion 24 and the corresponding luminescent panel 13. In this embodiment, another diffusion portion (diffusion sheet 25) is adhered with the adhesive 22 to a surface of each luminescent panel 13 that faces the brightness compensating member 21 (a surface of the transparent substrate 16). The diffusion surface 25a of the diffusion sheet 25 on each luminescent panel 13 faces the brightness compensating member 21. The brightness compensating member 21 is arranged so that the diffusion portions 24 are placed on the diffusion sheets 25 on the luminescent panels 13.

An operation of the lighting apparatus 12 configured as described above will hereafter be described. When the light emitting portions 14 are driven, the light emitting portions 14 emit white light. The white light exits from the lighting apparatus 12 through the diffusion sheets 25 and the brightness compensating member 21. Light emitted by the light emitting portions 14 that directly and linearly advances to the brightness compensating member 21 is believed to have a different color (wavelength) from light that advances in a slanting direction. Therefore, in a case where the transparent substrates 16 of the luminescent panels 13, the adhesive 22, and the brightness compensating member 21 are made of materials having the same or similar (within several percent) refractive index as in the first embodiment, the color of light that is reflected by each inclined surface 23b of each V-shaped groove 23 and exits through the brightness compensating member 21 is different from the color of sections of the brightness compensating member 21 that correspond to the light emitting portions 14. As a result, the color of sections of the brightness compensating member 21 that correspond to the non-light emitting portions 15 and through the space between the non-light emitting portions 15 of each adjacent pair of the luminescent panels 13 is different from the color of other sections of the brightness compensating member 21. Therefore, if the lighting apparatus 12 is used as a backlight of the color liquid crystal display 10, an image on the liquid crystal display appears with partial color defects.

However, in the second embodiment, the diffusion portions 24 are provided on sections of a surface of the brightness compensating member 21 that faces the luminescent panels 13 except for the V-shaped grooves 23. A space exists between each diffusion portion 24 and the corresponding luminescent panel 13. Thus, light that exits each luminescent panel 13 is incident on the brightness compensating member 21 through a layer of air. Since the refractive index of air is 1.0 and the refractive index of the transparent substrates 16 is 1.5, the angle of refraction at the layer of air is greater than the incident angle of light from the luminescent panel 13 to the layer of air due Snell's law. Thus, light that is incident on the layer of air from the luminescent panel 13 at a large incident angle is hardly incident on the brightness compensating member 21, while light emitted frontward from each luminescent panel 13, that is, light emitted in a direction along the thickness of the brightness compensating member 21 is easily incident on the brightness compensating member 21. Light that is emitted frontward of each luminescent panel 13 has a plurality of colors, and the intensities of light components each corresponding to a different color are equal to one another. Since such light is diffused at the diffusion portions 24 and is incident on the brightness compensating member 21, the color of the light reflected by the V-shaped grooves, that is, the color of sections of the brightness compensating member 21 that correspond to the non-light emitting portions 15 and the space between the non-light emitting portions 15 of the luminescent panels 13, becomes the same as the color of sections of the brightness compensating member 21 that correspond to the light emitting portions 14.

The second embodiment has the following advantages in addition to the advantages (1) to (5), and (7) to (9) of the first embodiment.

(10) The organic EL layer 18 is configured to emit white light. Therefore, when used as a backlight of a liquid crystal display, the lighting apparatus 12 can be applied to full color display using color filters.

(11) On a surface of the brightness compensating member 21 that faces the luminescent panels 13, the diffusion portions 24 are provided in sections except for the V-shaped grooves 23. The brightness compensating member 21 is arranged so that a space exists between each diffusion portion 24 and the corresponding luminescent panel 13. Therefore, if the color of light that directly and linearly advances to the light exit surface from the light emitting portions 14 through the transparent substrates 16 is different from the color of light that advances in a slanting direction, light that is reflected by the V-shaped grooves 23, or light that exits through sections of the brightness compensating members 21 that correspond to the non-light emitting portions, has the same color as light that exits through sections of the brightness compensating member 21 that correspond to the light emitting portions 14. As a result, in a case where the lighting apparatus 12 is used as a backlight of the color liquid crystal display 10, an image on the liquid crystal display is prevented from appearing with partial color defects.

(12) The diffusion portions 24 have diffusion sheets 25, which are optically integrated with the surface of the brightness compensating member 21 on a side where the V-shaped grooves 23 are formed. The diffusion surface 25a of the diffusion sheet 25 faces the luminescent panels 13. Therefore, compared to a case where the diffusion portions 24 are directly formed on the surface of the luminescent panels 13 of the brightness compensating member 21, the diffusion portions 24 are easily formed.

(13) The diffusion sheets 25 are attached to the luminescent panels 13. The diffusion surface 25a (functioning as diffusion portion) of the diffusion sheet 25 on each luminescent panel 13 faces the brightness compensating member 21. Therefore, compared to a case where the diffusion sheets 25 are not provided on the luminescent panels 13, the brightness increases that exits from the luminescent panels 13 and is incident on the brightness compensating member 21.

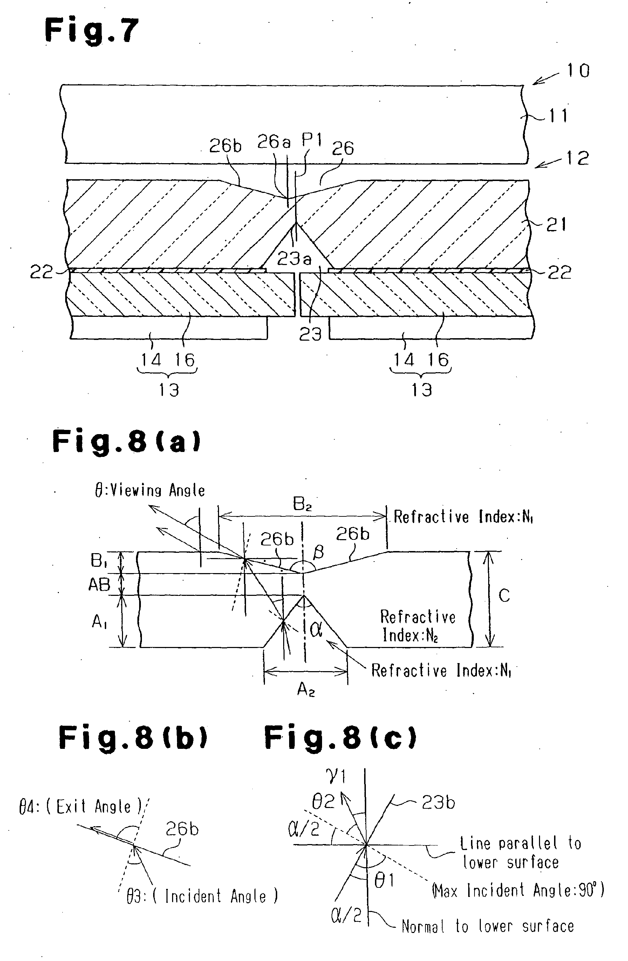

A third embodiment of the present invention will now be described with reference to Figs. 6 to 8(c). The third embodiment is different from the first embodiment in that a brightness compensating member 21 has a structure for reducing its thickness. The other structures are the same as the first embodiment. Similar or the same reference numerals are given to those components that are similar or the same as the corresponding components of the first embodiment and detailed explanations are omitted. Figs. 6 and 7 are partial cross-sectional views illustrating a liquid crystal display 10.

As shown in Figs. 6 and 7, a brightness compensating member 21 has second V-shaped grooves 26. Each second V-shaped groove 26 is formed in a section of the brightness compensating member 21 on which the V-shaped grooves 23 are formed. Specifically, each second V-shaped groove 26 is formed on a surface that is opposite to the surface facing the luminescent panels 13, and faces the corresponding first V-shaped groove 23. As shown in Figs. 6 and 7, a plane that is perpendicular to each luminescent panel 13, is parallel to the V-shaped groove 23, and contains a deepest portion 23a of the V-shaped groove 23 is referred to as an imaginary plane P1. Each second V-shaped groove 26 is may be formed so that its deepest portion 26a is located in the corresponding imaginary plane P1 as shown in Fig. 6, or so that the deepest portion 26a is not located in the corresponding imaginary plane P1 as shown in Fig. 7.

In a configuration as in the first embodiment, in which each V-shaped groove 23 is formed to face one of the luminescent panels 13 of the brightness compensating member 21, the depth $A_1$ of the V-shaped grooves 23, or the thickness of the brightness compensating member 21, is increased as the viewing angle $\theta$ is increased, although the degree of increase depends on the width $A_2$ of the open end of the V-shaped groove 23 and the refractive index $N_2$ of the brightness compensating member 21. As a result, even if the thickness of the luminescent panels 13 is reduced, the thickness of the entire lighting apparatus 12 is increased. For example, if the refractive index $N_2$ of the brightness compensating member 21 is set to 1.492, and the width $A_2$ of the open end is 2.2 mm, the depth $A_1$ of the V-shaped groove 23 is 10 mm when the viewing angle $\theta$ is approximately 82 degrees.

In the third embodiment, since the second V-shaped grooves 26 are formed on a surface of the brightness compensating member 21 that is opposite to the surface on which the V-shaped grooves 23 are formed, the depth $A_1$ of the V-shaped grooves 23 can be reduced for the same viewing angle. The thickness of the brightness compensating member 21 is reduced, accordingly. For the same thickness of the brightness compensating member 21, the viewing angle can be increased.

Referring to Figs. 8(a), 8(b), and 8(c), the procedure for obtaining equations for computing the viewing angle $\theta$ and setting the thickness of the brightness compensating member 21 will now be explained. As shown in Figs. 8(a) and 8(c), the equations for the lower side of the brightness compensating member 21 are the same as those in the first embodiments, and the equations (3), (5), and (6) are satisfied. However, in the equation (6), $\gamma1$ represents the angle defined by light that is incident on an inclined surface 23b of each V-shaped groove 23 at an incident angle of 90 degrees from the outside of the brightness compensating member 21 and the normal to the lower surface of the brightness compensating member 21.

$$\tan(\alpha/2) = (A_2/2)/A_1 \tag{3}$$

$$N_2\sin(\theta2) = N_1\sin(\theta1) = N_1 \tag{5}$$

$$\theta2 + \gamma1 + \alpha/2 = 90 \tag{6}$$

With respect to the upper surface of the brightness compensating member 21, the following equation is satisfied due to Snell's law if the incident angle of light that is incident on an air layer at an inclined surface 26b of each V-shaped groove 26 is expressed by $\theta3$, the apex angle of each second V-shaped groove 26 is expressed by $\beta$, and the angle of refraction is expressed by $\theta4$.

$$N_1\sin(\theta4) = N_2\sin(\theta3) \tag{7}$$

Referring to Figs. 8(a) and 8(b), the incident angle $\theta3$, the angle $\gamma1$, the exit angle $\theta4$, the viewing angle $\theta$, the apex angle $\beta$, the depth $B_1$ of each second V-shaped groove 26, and the width $B_2$ of the open end of each V-shaped groove 26 satisfy the following equations.

$$\theta3 = \gamma1 + (90 - \beta/2) \tag{8}$$

$$\theta = \theta4 - (90 - \beta/2) \tag{9}$$

$$\tan(90 - \beta/2) = B_1/(B_2/2) = 2B_1/B_2 \tag{11}$$

The apex angle $\beta$ of each second V-shaped groove 26 is defined so that the following equations are satisfied.

$$\tan(\gamma/1) = (B_2 - A_2) / (2C) \tag{11}$$

$$C = A_1 + AB + B_1 \tag{12}$$

Therefore, for example, once the apex angle $\alpha$ of the brightness compensating member 21 is determined, the depth $A_1$ of each V-shaped groove 23, the refractive angle $\theta2$, and the angle $\gamma1$ are determined based on the equations (3), (5), and (6). When the viewing angle $\theta$ is determined, the apex angle $\beta$ of the brightness compensating member 21 is obtained based on the equations (7), (8), and (9). Then, the depth $B_1$ and the width $B_2$ of the open end of each second V-shaped groove 26, and the thickness C of the brightness compensating member 21 are obtained based on the equations (10), (11), and (12).

As described above, by providing the V-shaped grooves 23 and the second V-shaped grooves 26 in the brightness compensating member 21, the viewing angle $\theta$ can be increased for the same thickness of the brightness compensating member 21, and the thickness of the brightness compensating member 21 can be reduced for the same viewing angle $\theta$. In this configuration, if the radii of curvature of each apex of the V-shaped groove 23 and the second V-shaped groove 26 are more than 0.05 mm, forming the V-shaped grooves 23 and the second V-shaped grooves 26 so that the deepest portion 26a of each second V-shaped groove 26 exists on the corresponding imaginary plane P1 can cause a defect. The reasons for this are as follows. In a case where the radii of curvature of each apex angle of the V-shaped grooves 23 and the second V-shaped grooves 26 are more than 0.05 mm, a flat section is formed at each of the deepest portions 23a, 26a. Therefore, when the brightness compensating member 21 is viewed from the light exit side of the lighting apparatus 12, dim lines appear at portions of the brightness compensating member 21 that correspond to the non-light emitting portions 15 since the deepest portions 23a, 26a are aligned. However, if the deepest portions 23a, 26a of the V-shaped grooves 23 and the second V-shaped grooves 26 are not aligned when the brightness compensating member 21 is viewed from the light exit side of the lighting apparatus 12 as shown in Fig. 7, dim lines do not appear at portions of the brightness compensating member 21 that correspond to the non-light emitting portions 15.

The third embodiment has the following advantages in addition to the advantages (1) to (9) of the first embodiment.

(14) Each second V-shaped groove 26 is formed in a section of the brightness compensating member 21 on which the V-shaped grooves 23 are formed. Specifically, each second V-shaped groove 26 is formed on a surface that is opposite to the surface facing the luminescent panels 13, and faces the corresponding first V-shaped groove 23. Compared to a configuration without the second V-shaped grooves 26, the thickness of the brightness compensating member 21 can be reduced for the same viewing angle.

(15) In the embodiment shown in Fig. 7, the deepest portion 26a of each second V-shaped groove 26 is not in the imaginary plane P1, which is perpendicular to each luminescent panel 13, is parallel to the V-shaped grooves 23, and contains the deepest portion 23a of the corresponding V-shaped groove 23. Therefore, even if the radii of curvature of each apex of the V-shaped grooves 23 and the second V-shaped grooves 26 are more than 0.05 mm, each deepest portion 23a and the corresponding deepest portion 26a are not aligned when viewed from the light exit side of the brightness compensating member 21. Thus, dim lines do not appear at portions of the brightness compensating member 21 that correspond to the non-light emitting portions 15.

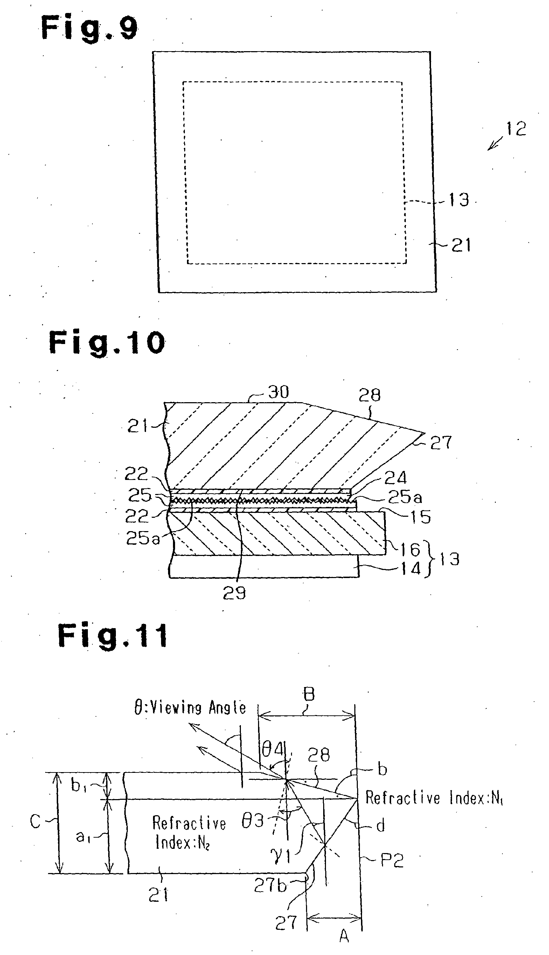

A fourth embodiment of the present invention will now be described with reference to Figs. 9 to 11. This embodiment is different from the previous embodiments in that only one luminescent panel 13 is provided instead of a plurality of luminescent panels 13. The other structures are the same as the second and third embodiments. Similar or the same reference numerals are given to those components that are similar or the same as the corresponding components of the previous embodiments and detailed explanations are omitted. Fig. 9 is a plan view illustrating a lighting apparatus, and Fig. 10 is a partial cross-sectional view illustrating the lighting apparatus.

As shown in Fig. 9, a lighting apparatus 12 includes a single luminescent panel 13 and a brightness compensating member 21. As in the first embodiment, the luminescent panel 13 includes a transparent substrate 16 and an organic electroluminescent (EL) element, which functions as an area light emitting element, formed on the transparent substrate 16. The luminescent panel 13 further includes a light emitting portion 14, which emits isotropic light, and a non-light emitting portion 15. That is, the light emitting portion 14 is formed of an organic EL element. In this embodiment, the non-light emitting portion 15 corresponds to a portion around the light emitting portion 14, or a peripheral portion of the luminescent panel 13. As shown in Fig. 10, a brightness compensating member 21 is arranged to cover the light emitting portion 14 and the non-light emitting portion 15 as viewed from the top. The brightness compensating member 21 includes an incident portion 29 and a light exit portion 30. The incident portion 29 includes a single inclined surface 27 that is inclined relative to the light exit portion 30. The inclined surface 27 is located in a portion of the brightness compensating member 21 that corresponds to the non-light emitting portion 15 of the luminescent panel 13. In this embodiment, the inclined surface 27 is located in a peripheral portion of the brightness compensating member 21. The inclined surface 27 is configured so that the brightness of a section of the brightness compensating member 21 that corresponds to the light emitting portion 14 is substantially equal to the brightness of a section of the brightness compensating member 21 that corresponds to the non-light emitting portion 15.

The inclined surface 27 is either optically polished or mirror finished. As shown in Fig. 11, when projected onto the luminescent panel 13, the width A of the inclined surface 27 is wider than the width of the non-light emitting portion 15.

As in the second embodiment, the light emitting portion 14 is formed of an organic EL element that includes an organic EL layer 18 for emitting white light.

On a surface of the brightness compensating member 21 that faces the luminescent panel 13, a diffusion portion 24 is provided in a section except for the inclined surface 27. The diffusion portion 24 is formed by attaching a diffusion sheet 25 onto the brightness compensating member 21. A diffusion sheet 25 is also attached to the surface of the brightness compensating member 21 that faces the transparent substrate 16.

Fig. 11 is a diagrammatic view showing the relationship of the viewing angle $\theta$, the inclined surface 27, and the thickness C of the brightness compensating member. To facilitate illustration, the diffusion portion 24 and other components are omitted. The inclined surface 27 is formed so that the distance $a_1$ from the distal end of the inclined surface 27, (an end of the inclined surface 27 that is farthest from the luminescent panel 13) to the luminescent panel 13, the width A of the inclined surface 27 when projected onto the luminescent panel 13, an angle d defined by the inclined surface 27 and a plane P2 that is perpendicular to the luminescent panel 13, the refractive index $N_1$ of air, the refractive index $N_2$ of the brightness compensating member, and the view angle $\theta$ satisfy the following two equations.

$$a_1 = A/\tan d \tag{21}$$

$$\theta = \arcsin [(N_2/N_1) \sin\{90 - d - \arcsin (N_1/N_2)\}] \tag{22}$$

A second inclined surface 28 is provided on the light exit portion 30 of the brightness compensating member 21. The second inclined surface 28 is inclined relative to the incident portion 29. The second inclined surface 28 is formed to correspond to the inclined surface 27.

In a configuration where the inclined surface 27 is provided on the incident portion 29 of the brightness compensating member 21, the distance $a_1$ from the distal end of the inclined surface 27 to the luminescent panel 13, that is, the thickness C of the brightness compensating member 21 is increased as the viewing angle $\theta$ is increased. The degree of increase depends on the projected width A and the refractive index $N_2$ of the brightness compensating member 21. As a result, even if the thickness of the luminescent panel 13 is reduced, the thickness of the entire lighting apparatus 12 is increased. For example, if the refractive index $N_2$ of the brightness compensating member 21 is 1.492, and the projected width A is 2.2 mm, the distance $a_1$ will be 10 mm when the viewing angle $\theta$ is approximately 82 degrees.

In this embodiment, a second inclined surface 28 is provided on the light exit portion 30 of the brightness compensating member 21. Hence, compared to a case where no second inclined surface 28 is formed, the distance $a_1$ can be reduced and the thickness C of the brightness compensating member 21 can be reduced for the same view angle $\theta$. For the same thickness C of the brightness compensating member 21, the viewing angle $\theta$ can be increased.

Referring to Fig. 11, the procedure for obtaining equations for computing the viewing angle $\theta$ and setting the

thickness C of the brightness compensating member 21 will now be explained. In this embodiment, the depth $A_1$ of each V-shaped groove 23, 1/2 of $A_2$ of the width $A_2$ of the open end of each V-shaped groove 23, 1/2 of the apex angle $\alpha$ of each V-shaped groove 23 are replaced by the distance $a_1$, the projected width A, the angle d defined by the inclined surface 27 and the plane perpendicular to the luminescent panel 13, respectively. Accordingly, the equations (23), (24) are satisfied instead of the equations (3), (5) of the first embodiment. However, in the equation (24), $\gamma 1$ represents the angle defined by light that is incident on the inclined surface 27 at an incident angle of 90 degrees from the outside of the brightness compensating member 21, and the normal to the lower surface of the brightness compensating member 21.

$$\tan d = A/a_1 \tag{23}$$

$$\theta 2 + \gamma 1 + d = 90 \tag{24}$$

With respect to the upper surface of the brightness compensating member 21, the following equation is satisfied due to Snell's law if the incident angle of light that is incident on an air layer at the second inclined surface 28 is expressed by $\theta 3$, the angle defined by the second inclined surface 28 and a plane P2 perpendicular to the luminescent panel 13 is expressed by b, and the light exit angle (refractive angle) is expressed by $\theta 4$.

$$N_1 \sin(\theta 4) = N_2 \sin(\theta 3) \tag{25}$$

The incident angle $\theta 3$, the angle $\gamma 1$, the exit angle $\theta 4$, the viewing angle , the angle b, the distance $b_1$ from the distal end of the second inclined surface 28 to a plane containing the exit surface of the brightness compensating member 21, and a width B of the second inclined surface 28 projected onto the plane containing the exit surface satisfy the following equations.

$$\theta 3 = \gamma 1 + (90 - b) \tag{26}$$

$$\theta = \theta 4 - (90 - b) \tag{27}$$

$$\tan(90 - b) = b_1/B \tag{28}$$

The angle b defined by the second inclined surface 28 and the plane P2 perpendicular to the luminescent panel 13 is defined so that the following equations are satisfied, that is, so that light that is incident on the brightness compensating member 21 through a proximal end 27b of the inclined surface 27 exits from the proximal end of the second inclined surface 28, while defining an angle $\gamma 1$.

$$\tan(\gamma/1) = (B - A)/C \tag{29}$$

$$C = a_1 + b_1 \tag{30}$$

The fourth embodiment has the following advantages in addition to the advantages (8) and (9) of the first embodiment, and the advantages (10) to (13) of the second embodiment.

(16) The lighting apparatus 12 includes the luminescent panel 13 and the brightness compensating member 21 The luminescent panel 13 includes the transparent substrate 16 and the electroluminescent (EL) element, which is formed on the transparent substrate 16. The luminescent panel 13 also includes the light emitting portion 14, which emits isotropic light, and the non-light emitting portion 15. The brightness compensating member 21 includes the incident portion 29 and the light exit portion 30. The incident portion 29 includes the single inclined surface 27 that is inclined relative to the light exit portion 30. The inclined surface 27 is located in a portion of the luminescent panel 13 that corresponds to the non-light emitting portion 15, so that the brightness of a section of the brightness compensating member 21 that corresponds to the light emitting portion 14 is substantially equal to the brightness of a section of the brightness compensating member 21 that corresponds to the non-light emitting portion 15. Therefore, a substantially uniform brightness is obtained from the light exit portion 30, the area of which is larger than the light emitting portion 14. That is, since light is totally reflected by the inclined surface 27, the brightness of a section of the brightness compensating member 21 that corresponds to the light emitting portion 14 is substantially equal to the brightness of a section of the brightness compensating member 21 that corresponds to the non-light emitting portion 15. The inclined surface 27 is provided on a part of the brightness compensating member 21 that faces the luminescent panel 13. Specifically, the inclined surface 27 is provided on a part that corresponds to the non-light emitting portion 15.

(17) The diffusion portion 24 is formed on a portion of the brightness compensating member 21 except for the inclined surface 27 of the incident portion 29. A space exists between the diffusion portion 24 and the luminescent panel 13. Light that is emitted frontward of the luminescent panel 13, or light emitted in a direction along the thickness of the brightness compensating member 21, has a plurality of colors, and the intensities of light components each corresponding to a different color are equal to one another. The light is diffused at the diffusion portion 24 and is incident on the brightness compensating member 21. Therefore, the color of the light reflected by the inclined surface 27, that is, the color of the section of the brightness compensating member 21 that corresponds to the non-light emitting portion 15 becomes the same as the color of the section of the brightness compensating member 21 that corresponds to the light emitting portions 14.

(18) The width A of the inclined surface 27 projected onto the luminescent panel 13 is wider than the width of the non-light emitting portion 15. If the width A of the inclined surface 27 projected onto the luminescent panel 13 is narrower than the width of the non-light emitting portion 15, the non-light emitting portion 15 is visible when the brightness compensating member 21 is viewed from the light exit side of the lighting apparatus 12. If the width A of the inclined surface 27 projected onto the luminescent panel 13 is made precisely the same as the width of the non-light emitting portion 15 of the luminescent panel 13, the non-light emitting portion 15 will be hidden. However, the machining will be difficult. However, in this embodiment, since the width A of the inclined surface 27 projected onto the luminescent panel 13 is made wider than the width of the non-light emitting portion 15, the non-light emitting portion 15 is hidden. That is, part of dim sections is prevented from appearing as dime lines.

(19) The inclined surface 27 is formed so that the equations (21) and (22) are satisfied. Thus, the angle d defined by the inclined surface 27 and the plane P2 perpendicular to the luminescent panel 13, and the distance $a_1$ from the distal end of the inclined surface 27 and the luminescent panel 13 are easily determined appropriately depending on which of reduction of the thickness C of the brightness compensating member 21 and increase of the viewing angle $\theta$ is given a higher priority.

(20) The inclined surface 27 is either optically polished or mirror finished. Therefore, compared to a case where the inclined surface 27 is not optically polished or mirror finished, attenuation of light due to scattering and absorption is reduced. Thus, the amount of light that is reflected by inclined surface 27 and exits through the light exit portion 30 of the brightness compensating member 21 is increased. Thus, light emitted by the light emitting portions 14 is effectively used.

(21) The light exit portion 30 of the brightness compensating member 21 includes the single second inclined surface 28 that is inclined relative to the incident portion 29, and the second inclined surface 28 is formed at a position that corresponds to the inclined surface 27. Compared to a configuration without the second inclined surface 28, the thickness of the brightness compensating member 21 can be reduced for the same viewing angle $\theta$.

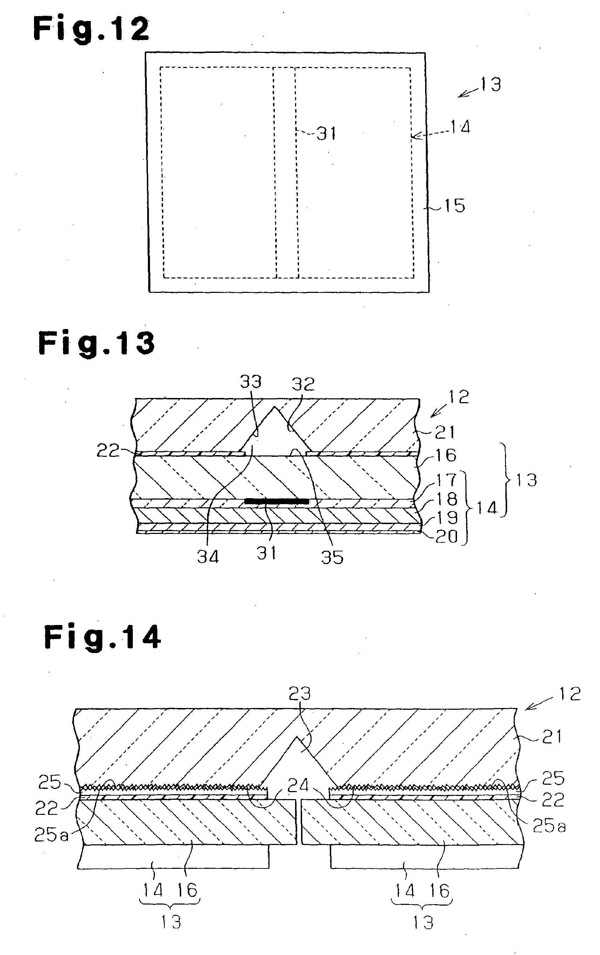

A fifth embodiment of the present invention will now be described with reference to Figs. 12 and 13. The fifth embodiment is different from the first to fourth embodiments in that a portion on which an auxiliary electrode 31 is formed forms a non-light emitting portion 35. Similar or the same reference numerals are given to those components that are similar or the same as the corresponding components of the previous embodiments and detailed explanations are omitted. Fig. 12 is a plan view illustrating a luminescent panel 13, and Fig. 13 is a partial cross-sectional view illustrating the luminescent panel 13.

A light emitting portion 14 is formed of an organic electroluminescent element. A transparent first electrode 17 is provided on a side of the light emitting portion 14 at the transparent substrate 16. The transparent electrode is formed, for example, of indium tin oxide (ITO) or zinc oxide (ZnO). Since the value of electric resistance of the transparent electrode is not sufficiently low, the difference between the electric resistance value at a section close to a connector terminal (not shown) and that at a section far from the terminal is increased. Accordingly, the values of currents through the organic EL layer 18 greatly vary. When the area of the transparent electrode is increased, variation of the current value of currents through the organic EL layer 18 among different sections is increased. Since the luminescence of the organic EL element is affected by the current value, the luminescence will be uneven. To suppress the brightness unevenness, an auxiliary electrode 31 is provided on the transparent first electrode 17.

The auxiliary electrode 31 is formed on the transparent substrate 16. The first electrode 17 is formed to cover the auxiliary electrode 31. The auxiliary electrode 31 is electrically connected to the first electrode 17. The auxiliary electrode 31 has a resistance lower than that of the first electrode 17, and is made of a metal or an alloy, such as aluminum. Since the auxiliary electrode 31 is opaque, a portion of the brightness compensating member 21 that corresponds to the auxiliary electrode 31 forms the non-light emitting portion 35. As shown in Fig. 13, the brightness compensating member 21 includes a V-shaped groove 34, which has two inclined surfaces 32, 33 of different inclined directions. The V-shaped groove 34 is provided to correspond to the non-light emitting portion 35 of the auxiliary electrode 31.

The transparent electrode is made of a material having the volume resistivity that is higher than that of a metal electrode. Therefore, if the area of the light emitting portion 14 is increased without forming the auxiliary electrode 31, variation of the current density of currents through the organic EL layer at different sections is increased, which results in an uneven brightness. However, in this embodiment, the auxiliary electrode 31 is provided in a state electrically connected to the transparent electrode. This reduces the variation of the current density among different sections of the light emitting portion 14, which curbs brightness unevenness of the entire light emitting portion 14.

Since the auxiliary electrode 31 is opaque, simply providing the auxiliary electrode 31 does not prevent a portion of the light exit surface of the brightness compensating member 21 that corresponds to the auxiliary electrode 31 from being dim. However, since the brightness compensating member 21 has the V-shaped groove 34 at a section that corresponds to the auxiliary electrode 31, the brightness of a section of the brightness compensating member 21 that corresponds to the light emitting portion 14 is substantially equal to the brightness of a section of the brightness compensating member 21 that corresponds to the non-light emitting portion 35.

This embodiment therefore has the following advantages.

(22) The auxiliary electrode 31 is electrically connected to the transparent first electrode 17. This reduces brightness unevenness of the entire lighting apparatus 12 compared to a case where no auxiliary electrode 31 is provided.

(23) The brightness compensating member 21 includes the V-shaped groove 34, which has the two inclined surfaces 32, 33 of different inclined directions. The V-shaped groove 34 is provided to correspond to the non-light emitting portion 35 of the auxiliary electrode 31. Therefore, in the present embodiment, the non-light emitting portion 35 created by the auxiliary electrode 31 is made inconspicuous.

The invention may be embodied in the following forms.

In the second embodiment, the diffusion portions 24 are formed by attaching the diffusion sheets 25 on the surface of the brightness compensating member 21 that faces the luminescent panels 13. The diffusion portions 24 are provided in sections except for the V-shaped grooves 23. Instead, as shown in Fig. 14, the diffusion portions 24 may be each directly formed on a surface of the brightness compensating member 21 that faces the luminescent panel 13. Further, the diffusion portions 24 may be provided in the manner disclosed in the fourth embodiment.

In the second and fourth embodiments, the diffusion sheets 25 on the luminescent panels 13 may be removed.

In the second and fourth embodiments, the brightness compensating member 21 having the diffusion portions 24 is placed on the luminescent panels 13. Instead of this configuration, the brightness compensating member 21 may be configured so that the diffusion portions 24 are completely separate from the luminescent panels 13.

The transparent substrates 16 and the brightness compensating member 21 do not need to be made of glass, but may be made of any material as long as it is transparent. For example, the transparent substrates 16 and the transparent brightness compensating member 21 may be formed of resin.

The configuration of the third embodiment, in which the second V-shaped grooves 26 are formed on the brightness compensating member 21, may be applied to the second and fifth embodiments. That is, in the second and fifth embodiments, second V-shaped grooves 26 may be formed in sections corresponding to the V-shaped grooves 23, 34 of the brightness compensating member 21.

The organic EL elements forming the light emitting portions 14 do not need to have a configuration to emit light through the transparent substrates 16. Instead, as shown in Fig. 15(a), top emission type organic EL elements that emit light from a side opposite to the transparent substrate 16 may be used. In each luminescent panel 13, a transparent substrate 16 is located on a side of a light emitting portion 14 opposite to the brightness compensating member 21. The organic EL element has a first electrode 17 and a transparent second electrode 19. The first electrode 17 may be either a transparent electrode or an opaque electrode. The transparent substrates 16 may be replaced by opaque substrates. When top emission type organic EL elements are used, since the organic EL elements face the brightness compensating member 21, the brightness compensating member 21 and the luminescent panels 13 need to be assembled so that the organic EL elements are not damaged.

In a case of a lighting apparatus 12 having a single luminescent panel 13 as in the fourth embodiment, the apparatus 12 may be configured without a diffusion portion 24 or without second V-shaped grooves 26 as in the first embodiment.

In a configuration where an auxiliary electrode 31 is provided as in the fifth embodiment, the number and position of the auxiliary electrode 31 may be changed according to factors such as the area of the light emitting portion 14. For example, a plurality of auxiliary electrodes 31 may be provided. Alternatively, unlike the embodiment of Fig. 12 in which the light emitting portion 14 is divided by the auxiliary electrode 31, the auxiliary electrode 31 may extend only to a center portion of the light emitting portion 14.

In the fifth embodiment, the auxiliary electrode 31 is formed on the transparent substrate 16. However, the auxiliary electrode 31 may be formed on the transparent first electrode 17. That is, the first electrode 17, the auxiliary electrode 31, the organic EL layer 18, and the second electrode 19 may be formed on the transparent substrate 16 in this order.

The luminescent panels 13 of the lighting apparatuses 12 according to the first to third embodiments may be replaced by luminescent panels 13 each having an auxiliary electrode 31. In this case, since the V-shaped grooves 23, 34 are formed in sections of the brightness compensating member 21 that correspond to the non-light emitting portions 35 created by the auxiliary electrodes 31, such non-light emitting portions 35 are made inconspicuous.

In the fifth embodiment, the V-shaped groove 34 is formed only in a section of the brightness compensating member 21 that corresponds to the non-light emitting portion 35 formed by the auxiliary electrode 31. This configuration may be changed. It may be configured so that an inclined surface 27 corresponds to the non-light emitting portion 15 located at an end of the luminescent panel 13 that corresponds to the peripheral portion of the light emitting portion 14, and that a V-shaped groove 34 is formed in the non-light emitting portion 35 created by the auxiliary electrode 31. An inclined surface of the brightness compensating member 21 formed at a position corresponding to the non-light emitting portion 15 may be a second inclined surface 28.

The organic EL layer 18 does not need to be configured to emit white light, but may be configured to emit single color light, such as red, green, blue or yellow light, or may be configured to emit light of combination of these colors.

Instead of organic EL elements, inorganic EL elements may be used as the light emitting portions 14.

As long as the light emitting portions 14 emit isotropic light, light emitting portions other than EL elements may be used.

The lighting apparatus 12 does not need to be used as a backlight, but may be used as a light source of other lighting apparatus or displays.

Therefore, the present examples and embodiments are to be considered as illustrative and not restrictive and the invention is not to be limited to the details given herein, but may be modified within the scope and equivalence of the appended claims.

**Claims**

1. A lighting apparatus, comprising:

   a luminescent panel having a light emitting portion for emitting isotropic light and a non-light emitting portion, the apparatus being **characterized by**:

   a brightness compensating member having an incident portion, on which light is incident, and a light exit portion, through which light exits, wherein the incident portion includes at least one inclined surface that is inclined relative to the light exit portion,

   wherein the inclined surface is arranged to correspond to the non-light emitting portion and is configured so that the brightness of a section of the brightness compensating member that corresponds to the light emitting portion is substantially equal to the brightness of a section of the brightness compensating member that corresponds to the non-light emitting portion.

2. The apparatus according to claim 1, **characterized in that** the luminescent panel includes a substrate and an area light emitting element formed on the substrate, and
   wherein the non-light emitting portion includes a section of the substrate on which the area light emitting element is not formed.

3. The apparatus according to claim 1 or 2, **characterized in that** the non-light emitting portion is located around the light emitting portion and in a peripheral portion of the luminescent panel.

4. The apparatus according to claim 3, **characterized in that** the luminescent panel is one of a plurality of adjoining luminescent panels, wherein the non-light emitting portions are adjacent to each other, and
wherein the brightness compensating member is formed of a transparent plate and is arranged at a side of the luminescent panels through which light exits to correspond to the luminescent panels, and wherein the inclined surface extends along the peripheral portions of the luminescent panels.

5. The apparatus according to any one of claims 1 to 4, **characterized in that** the brightness compensating member is formed of a transparent plate, and includes a V-shaped groove formed to correspond to the non-light emitting portion, and wherein at least one of a pair of inclined surfaces define the V-shaped groove is formed of the inclined surface.

6. The apparatus according to any one of claims 1 to 5, **characterized in that** the non-light emitting portion is one of a plurality of non-light emitting portions, the non-light emitting portions including a non-light emitting portion that is located in a peripheral portion of the luminescent panel and a non-light emitting portion that is not located in the peripheral portion,
wherein the inclined surface corresponds to the non-light emitting portion that is located in the peripheral portion of the luminescent panel, and
wherein the brightness compensating member includes a V-shaped groove that is not located in the peripheral portion of the luminescent panel, and wherein the V-shaped groove is defined by a pair of inclined surfaces that have the same function as said inclined surface.

7. The apparatus according to claim 6, **characterized in that** the luminescent panel has an auxiliary electrode, wherein a section of each luminescent panel on which the auxiliary electrode is formed forms the non-light emitting portion that is not located in the peripheral portion of the luminescent panel.

8. The apparatus according to any one of claims 5 to 7, **characterized in that** the V-shaped groove is a first V-shaped groove, and
wherein the brightness compensating member includes a second V-shaped groove that is located on a side opposite to the luminescent panel and corresponds to the first V-shaped groove.

9. The apparatus according to claim 8, **characterized in that** a deepest portion of the second V-shaped groove is displaced from an imaginary plane that is perpendicular to the luminescent panel and contains a deepest portion of the first V-shaped groove.

10. The apparatus according to any one of claims 1 to 9, **characterized in that** the luminescent panel includes a substrate and an area light emitting element formed on the substrate, and
wherein the area light emitting element has an auxiliary electrode, and wherein the non-light emitting portion includes a section of the area light emitting element on which the auxiliary electrode is formed.

11. The apparatus according to claim 10, **characterized in that** the luminescent panel is one of a plurality of adjoining luminescent panels, and
wherein the brightness compensating member is formed of a transparent plate and is arranged at a side of the luminescent panels through which light exits to correspond to the luminescent panels.

12. The apparatus according to any one of claims 1 to 11, **characterized in that**, when projected onto the luminescent panel, the inclined surface has a width that is wider than the width of the non-light emitting portion.

13. The apparatus according to any one of claims 1 to 12, **characterized in that** a distance $a_1$ from an end of the inclined surface that is farthest from the luminescent panel to the luminescent panel, a width A of the inclined surface when projected onto the luminescent panel, an angle d defined by the inclined surface and a plane that is perpendicular to the luminescent panel, a refractive index $N_1$ of air, a refractive index $N_2$ of the brightness compensating member, and a view angle $\theta$ satisfy the following two equations:

$$a_1 = A/\tan d \tag{1}$$

$$e = \arcsin[(N_2/N_1)\sin\{90 - d - \arcsin(N_1/N_2)\}] \tag{2}$$

**14.** The apparatus according to any one of claims 1 to 13, **characterized in that** the inclined surface is either optically polished or mirror finished.

**15.** The apparatus according to any one of claims 1 to 14, **characterized in that** the inclined surface is a first inclined surface, and wherein the light exit portion includes at least one second inclined surface that is inclined relative to the incident portion, the second inclined surface being arranged to correspond to the first inclined surface.

**16.** The apparatus according to any one of claims 1 to 15, **characterized in that** the light emitting portion emits white light, wherein a diffusion portion is provided on a surface of the brightness compensating member that faces the luminescent panel except for the inclined surface, and
wherein the brightness compensating member is arranged so that a space exists between the diffusion portion and the luminescent panel.

**17.** The apparatus according to claim 16, **characterized in that** the diffusion portion is formed of a diffusion sheet having a diffusion surface, and wherein the diffusion sheet is optically integrated with the brightness compensating member so that the diffusion surface faces the luminescent panel.

**18.** The apparatus according to claim 16, **characterized in that** the diffusion portion is directly formed on a surface of the brightness compensating member that faces the luminescent panel.

**19.** The apparatus according to any one of claims 16 to 18, **characterized in that** a diffusion portion is formed on a surface of the luminescent panel that faces the brightness compensating member, and wherein the diffusion portion includes a diffusion surface that faces the brightness compensating member.

**20.** The apparatus according to any one of claims 1 to 15, **characterized in that** the brightness compensating member is attached to the luminescent panel with a transparent adhesive, the refractive index of the adhesive being equal to or within a several percent difference from the refractive index of the brightness compensating member.

**21.** The apparatus according to claim 2 or 10, **characterized in that** the area light emitting element is formed of an organic EL element.

**22.** The apparatus according to any one of claims 1 to 21, **characterized in that the** lighting apparatus is used as a backlight of a liquid crystal display.

**23.** The apparatus according to claim 22, **characterized in that** the ratio of the luminance of a section of the brightness compensating member that corresponds to the non-light emitting portion to the luminance of a section of the brightness compensating member that corresponds to the light emitting portion is no less than 0.8.

**24.** A lighting apparatus, comprising:

a plurality of luminescent panels each having a light emitting portion for emitting isotropic light and a non-light emitting portion provided around the light emitting portion, wherein the luminescent panels are arranged so that the non-light emitting portions are adjacent to each other,
the apparatus being **characterized by**:

a brightness compensating member that is formed of a transparent plate and is arranged at a side of the luminescent panels through which light exits to correspond to the luminescent panels,

wherein a surface of the brightness compensating member that faces the luminescent panels has a V-shaped groove that extends along the non-light emitting portions, wherein the V-shaped groove is formed so that the brightness of a section of the brightness compensating member that corresponds to the light emitting portion is substantially equal to the brightness of a section of the brightness compensating member that corresponds to the non-light emitting portions.

25. The apparatus according to claim 24, **characterized in that** an open end of the V-shaped groove has a width that is wider than the space between each adjacent pair of the light emitting portions.

26. The apparatus according to claim 24 or 25,
**characterized in that**

a depth $A_1$ of the V-shaped groove, a width $A_2$ of the open end of the V-shaped groove, an apex angle $\alpha$ of the V-shaped groove, a refractive index $N_1$ of air, a refractive index $N_2$ of the brightness compensating member, and a viewing angle $\theta$ satisfy the following two equations:

$$A_1 = A_2/\{2\tan(\alpha/2)\} \tag{1}$$

$$\theta = \arcsin\left[(N_2/N_1)\,\sin\{90 - \alpha/2 - \arcsin(N_1/N_2)\}\right] \tag{2}$$

27. A lighting apparatus, comprising:

a plurality of adjoining luminescent panels each having a light emitting portion for emitting isotropic light and an auxiliary electrode, wherein a section of each luminescent panel on which the auxiliary electrode is formed forms a non-light emitting portion,
the apparatus being **characterized by**:

a brightness compensating member that is formed of a transparent plate and is arranged at a side of the luminescent panels through which light exits to correspond to the luminescent panels,

wherein a surface of the brightness compensating member that faces the luminescent panels has a V-shaped groove that is arranged to correspond to the non-light emitting portions, wherein the V-shaped groove is formed so that the brightness of a section of the brightness compensating member that corresponds to the light emitting portions is substantially equal to the brightness of a section of the brightness compensating member that corresponds to the non-light emitting portions.

28. A lighting apparatus, comprising:

a plurality of luminescent panels each having a light emitting portion for emitting isotropic light and a non-light emitting portion provided around the light emitting portion, wherein the luminescent panels are arranged so that the non-light emitting portions are adjacent to each other,
the apparatus being **characterized by**:

a brightness compensating member that is formed of a transparent plate and is arranged at a side of the luminescent panels through which light exits to correspond to the luminescent panels,

wherein a surface of the brightness compensating member that faces the luminescent panels has a V-shaped groove that extends along the non-light emitting portions, wherein the V-shaped groove is formed so that the brightness of a section of the brightness compensating member that corresponds to the non-light emitting portion is increased to approaches the brightness of a section of the brightness compensating member that corresponds to the light emitting portions.

# Fig.1 (a)

# Fig.1 (b)

# Fig.2

# Fig.3

# Fig.4(a)

Refractive Index:N₁

Refractive Index:N₂

Refractive Index:N₁

# Fig.4(b)

Line parallel to lower surface

(Max Incident Angle:90°)

Normal to lower surface

## Fig.5

## Fig.6

# Fig.7

# Fig.8(a)

# Fig.8(b)    Fig.8(c)

# Fig.9

12
13
21

# Fig.10

30  28
21
27
22
25  24
25a
22  15
25a
16
14  13
29

# Fig.11

θ:Viewing Angle
B
θ4  28
b
b₁  Refractive Index:N₁
C  θ3  d
Refractive Index:N₂
a₁  γ₁
P2
21  27b
27
A

**Fig.12**

**Fig.13**

**Fig.14**

# Fig.15(a)

# Fig.15(b)

# Fig.16

# Fig.17

**European Patent Office**

# EUROPEAN SEARCH REPORT

Application Number

EP 05 01 0349

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,X | PATENT ABSTRACTS OF JAPAN vol. 2003, no. 02, 5 February 2003 (2003-02-05) & JP 2002 297065 A (SANYO ELECTRIC CO LTD), 9 October 2002 (2002-10-09) | 1 | H05B33/14 H05B33/12 H01J1/62 |
| Y | * abstract * | 1-28 | |
| X | PATENT ABSTRACTS OF JAPAN vol. 2003, no. 12, 5 December 2003 (2003-12-05) & JP 2003 257659 A (MATSUSHITA ELECTRIC IND CO LTD), 12 September 2003 (2003-09-12) * abstract * | 1 | |
| X | US 2003/094897 A1 (KOYAMA TOMOKO ET AL) 22 May 2003 (2003-05-22) | 1 | |
| Y | * paragraphs [0065] - [0120]; claims 1-13; figures 1-3 * | 1-28 | |

TECHNICAL FIELDS SEARCHED (Int.Cl.7)

H05B
H01J

The present search report has been drawn up for all claims

| Place of search | Date of completion of the search | Examiner |
|---|---|---|
| The Hague | 25 August 2005 | Wengeler, H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 1 596 638 A1**

**ANNEX TO THE EUROPEAN SEARCH REPORT
ON EUROPEAN PATENT APPLICATION NO.**

EP 05 01 0349

This annex lists the patent family members relating to the patent documents cited in the above-mentioned European search report.
The members are as contained in the European Patent Office EDP file on
The European Patent Office is in no way liable for these particulars which are merely given for the purpose of information.

25-08-2005

| Patent document cited in search report | | Publication date | Patent family member(s) | | Publication date |
|---|---|---|---|---|---|
| JP 2002297065 | A | 09-10-2002 | NONE | | |
| JP 2003257659 | A | 12-09-2003 | US | 2003164679 A1 | 04-09-2003 |
| US 2003094897 | A1 | 22-05-2003 | JP | 2003133057 A | 09-05-2003 |

EPO FORM P0459

For more details about this annex : see Official Journal of the European Patent Office, No. 12/82